Europäisches Patentamt

European Patent Office

Office européen des brevets

(19)

(11) Veröffentlichungsnummer: **0 210 367 B1**

(12) # EUROPÄISCHE PATENTSCHRIFT

(45) Veröffentlichungstag der Patentschrift: 06.03.91

(51) Int. Cl.⁵: **H03K 17/94**

(21) Anmeldenummer: 86107068.8

(22) Anmeldetag: 23.05.86

(54) **Einrichtung zur Impulsansteuerung von Optokopplern.**

(30) Priorität: 24.07.85 DE 3526459

(43) Veröffentlichungstag der Anmeldung:
04.02.87 Patentblatt 87/06

(45) Bekanntmachung des Hinweises auf die
Patenterteilung:
06.03.91 Patentblatt 91/10

(84) Benannte Vertragsstaaten:
**AT CH DE FR GB IT LI**

(56) Entgegenhaltungen:
**EP-A- 0 119 568**

**IEEE TRANSACTIONS ON CONSUMER ELEC-
TRONICS, Band CE-25, Nr. 4, August 1979,
Seiten 440-445, IEEE, New York, US; M. OZA-
WA et al.: "New protable video cassette recorder"**

**IBM TECHNICAL DISCLOSURE BULLETIN,
Band 25, Nr, 7A, Dezember 1982, Seiten
3478-3479, New York, US; C.N. BUSTAMANTE
et al.: "Dynamic optic coupler"**

**RADIO FERNSEHEN ELEKTRONIK, Band 29,
Nr. 3, 1980, Seiten 192-193, Berlin, DE; M.
GEISLER et al.: "Elektronische Bandlaufkon-**

trolle in Kassettentonbandgeräten"

(73) Patentinhaber: **GRUNDIG E.M.V. Elektro-
Mechanische Versuchsanstalt Max Grundig
holländ. Stiftung & Co. KG.
Kurgartenstrasse 37
W-8510 Fürth/Bay.(DE)**

(72) Erfinder: **Kornhaas, Wolfgang
Buschweg 26
W-8510 Fuerth(DE)**

## Beschreibung

Die Erfindung betrifft eine Einrichtung zur Impulsansteuerung von Optokopplern der im Oberbegriff des Patentanspruchs angegebenen Art.

Für die Erkennung von Bandanfang und Bandende beispielsweise in Videorecordern werden üblicherweise Optokoppler verwendet. Diese bestehen aus Leuchtdioden, die während der gesamten Betriebsdauer des Videorecorders von einem Gleichstrom durchflossen werden, und Empfängerelementen, die das von den Leuchtdioden emittierte Licht, das beispielsweise die Transmissionsfolie am Bandende eines Magnetbandes durchleuchtet, aufnehmen und an eine Auswerteschaltung weiterleiten, beispielsweise einen Mikrocomputer, der dann den Bandtransportmotor abschaltet.

Ferner sind Optokoppler bekannt, bei denen die Leuchtdiode ständig von einem impulsförmigen Strom mit definiertem Stromfluß-Pause-Verhältnis durchflossen wird. Auf der Empfangsseite werden die Stromimpulse in eine auswertbare Spannung umgewandelt.

Weiterhin können Optokoppler auch zur Erkennung von Bandrissen verwendet werden, da auch in diesen Fällen die Empfängerelemente das von den Leuchtdioden emittierte Licht aufnehmen und an die Auswerteschaltung weiterleiten. An deren Ausgang liegt dann, ebenso wie bei der Erkennung des Bandende-Zustandes, ein charakteristischer Spannungspegel an, der die Abschaltung des Bandtransportmotors auslöst.

Nachteilig bei diesen bekannten Einrichtungen ist, daß durch die ununterbrochene Ansteuerung der Leuchtdioden der Stromverbrauch der Schaltung hoch ist, zumal es zur sicheren Erkennung von Bandanfang und Bandende in der Praxis notwendig ist, einen hohen Strom durch die Leuchtdiode zu schicken und/oder die notwendige Empfindlichkeit der Empfängerelemente (z. B. Fototransistoren) durch den Einsatz großflächiger und damit teurer Empfängerelemente zu erreichen. Der ständige Stromfluß durch die Leuchtdioden führt ferner zu einer schnellen Alterung bzw. Lebensdauerverringerung der Leuchtdioden.

Weiterhin ist aus der Zeitschrift "IEEE Transactions on Consumer Electronics", Vol. CE-25, August 1979, S. 440-445, ein Videorecorder bekannt, welcher zur Bandendeerkennung eine Einrichtung zur Impulsansteuerung von Optokopplern mit den im Oberbegriff des Patentanspruchs angegebenen Merkmalen aufweist.

Die Aufgabe der Erfindung besteht darin, einen Weg aufzuzeigen, wie bei einer derartigen Einrichtung zur Impulsansteueuerung von Optokopplern der Stromverbrauch weiter gesenkt werden kann.

Diese Aufgabe wird durch die im kennzeichnenden Teil des Patentanspruchs angegebenen Merkmale gelöst.

Die Vorteile der Erfindung liegen darin, daß die Leuchtdioden nur während der unbedingt notwendigen Zeit mit Strom belastet werden. Dies bedeutet eine Verringerung des Stromverbrauchs des Gerätes, was insbesondere bei batteriebetriebenen Geräten von Vorteil ist. Ferner kann durch die nur kurzzeitige Strombelastung der die Leuchtdioden durchfließende Strom so hoch sein, daß empfängerseitig bereits normale, d.h. billige, Fototransistoren zu einer sicheren Bandanfangs- bzw. Bandendeerkennung ausreichen. Auch die Lebensdauer der Leuchtdioden wird durch die nur kurzzeitige Strombelastung erhöht.

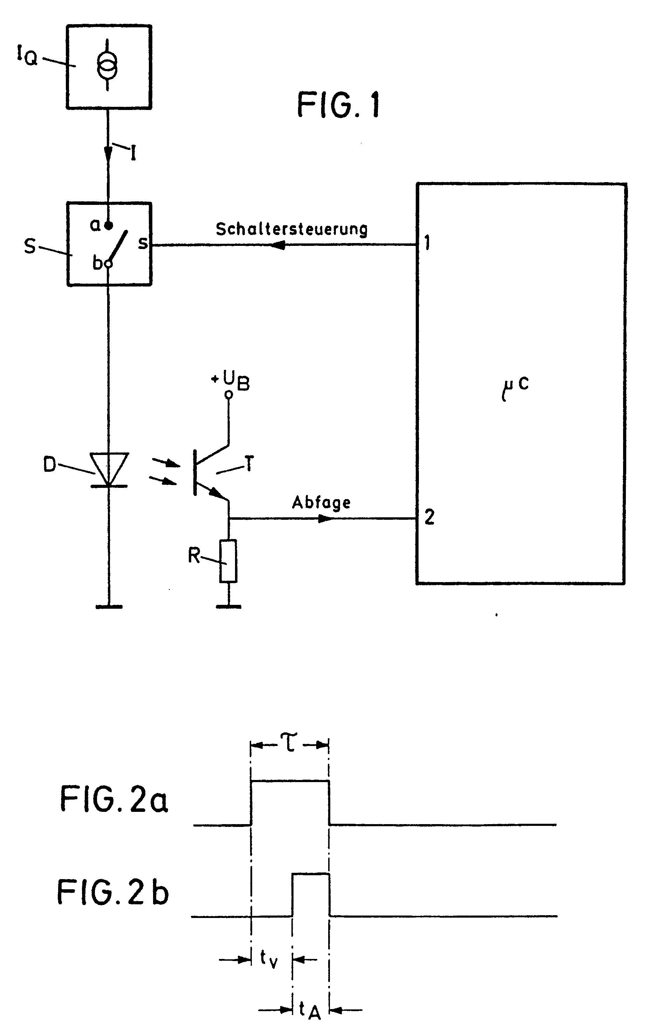

Weitere vorteilhafte Eigenschaften der Erfindung ergeben sich aus einem Ausführungsbeispiel, welches im folgenden anhand der Figuren 1 und 2 näher erläutert wird.

Der von einer Stromquelle $I_Q$ gelieferte Strom I wird einem Kontakt a eines Schalters S zugeführt. Der Kontakt b des Schalters S ist über eine Leuchtdiode D mit Masse verbunden. Zur Aufnahme des von der Leuchtdiode D emittierten Lichtes ist ein Fototransistor T vorgesehen, dessen Kollektor an einer Spannungsquelle $+ U_B$ liegt, und dessen Emitter einerseits an einen Eingang 2 eines Mikrocomputers $\mu$ C und andererseits über einen Widerstand R an Masse angeschlossen ist. Der Mikrocomputer $\mu$ C besitzt ferner einen Ausgang 1, der mit dem Steuereingang s des Schalters S verbunden ist.

Im Betrieb der erfindungsgemäßen Einrichtung steuert der Mikrocomputer $\mu$ C, der in heutigen Videorecordern für eine Vielzahl von Aufgaben benötigt wird, - kurz bevor er zur Abfrage des am Emitter des Fototransistors T anliegenden Spannungspegels bereit ist -, über seinen Ausgang 1 den Schalter S leitend, so daß ein Strom I über die Leuchtdiode D nach Masse fließt. Die Dauer der Stromflußzeit sei mit $\tau$ (siehe Fig. 2a) bezeichnet. Während dieser Zeit empfängt der Fototransistor T das von der Leuchtdiode D emittierte Licht, setzt es in einen Spannungspegel um, und leitet diesen an den Abfrageeingang 2 des Mikrocomputers $\mu$ C weiter. Die Abfrage des Spannungspegels am Eingang 2 des Mikrocomputers $\mu$ C erfolgt während eines Zeitintervalls $t_A$ (siehe Fig. 2b), dessen Beginn gegenüber dem Beginn des Stromflusses durch die Leuchtdiode um die Zeitdauer $t_V$ (siehe Fig. 2b) verzögert ist. Die Zeitdauer $t_V$ entspricht der Zeitdauer, die der Optokoppler benötigt, um nach dem Einschalten des Stromflusses einen zur Auswertung geeigneten Spannungspegel aufzubauen. Die Stromflußzeit $\tau$ muß in der

Praxis an die Zeitdauer $t_V$ angepaßt werden. Am Ende der Abfragezeit $t_A$, die mit dem Ende der Stromflußzeit $\tau$ zusammenfällt, öffnet der Mikrocomputer $\mu$ C über seinen Ausgang 1 den Schalter S, so daß der Stromfluß durch die Leuchtdiode D unterbrochen wird. Erst kurz bevor der Mikrocomputer $\mu$ C den Spannungspegel an seinem Eingang 2 erneut abfragt, schaltet er über seinen Ausgang 1 den Schalter S erneut leitend, und die oben beschriebenen Vorgänge wiederholen sich. In der Zeit zwischen den Abfragevorgängen steht der Mikrocomputer für seine übrigen Aufgaben zur Verfügung.

Gemäß der vorliegenden Erfindung ist kein ununterbrochener Stromfluß (Gleichstrom oder Impulsstrom) durch die Leuchtdiode erforderlich. Der Strom durch die Leuchtdiode wird vom Mikrocomputer nur dann eingeschaltet, wenn der Mikrocomputer den Spannungspegel am Ausgang des Fotoempfängers abfragt. Bei der beispielhaften Anwendung in Videorecordern erfolgt dies in Zeitabständen, welche vom Wickelzustand des Bandes innerhalb der Kassette abhängen.

## Ansprüche

1. Einrichtung zur Impulsansteuerung von Optokopplern zur Erkennung von Bandanfang und Bandende eines Magnetbandes, mit
   - einer Stromquelle zur Erzeugung eines eine Leuchtdiode durchfließenden Stromes,
   - einem Fotoempfänger zum Empfang des von der Leuchtdiode emittierten Lichtes,
   - einem Mikrocomputer $\mu$C zur Auswertung des am Ausgang des Fotoempfängers anliegenden Spannungspegels, und
   - einem vom Mikrocomputer gesteuerten und mit der Leuchtdiode verbundenen Schalter (S) der nur im durchlässigen Zustand einen Stromfluß durch die Leuchtdiode erlaubt, **dadurch gekennzeichnet,** daß der Mikrocomputer ($\mu$C) in vom Wickelzustand des Magnetbandes abhängigen Zeitabständen den Schalter (S) durchlässig steuert und den am Ausgang des Fotoempfängers anliegenden Spannungspegel auswertet.

## Claims

1. Device for the pulse activation of optocouplers for the detection of beginning of tape and end of tape of a magnetic tape, having
   - a current source for the generation of a current flowing through a light-emitting diode,
   - a photoreceiver for reception of the light emitted by the light-emitting diode,
   - a microcomputer ($\mu$C) for evaluation of the voltage level present at the output of the photoreceiver, and
   - a switch (S) controlled by the microcomputer and connected to the light-emitting diode, which switch allows a current to flow through the light-emitting diode only in the conducting state, characterized in that the microcomputer ($\mu$C) controls the switch (S) so as to be conductive at intervals of time dependent on the winding state of the magnetic tape and evaluates the voltage level present at the output of the photoreceiver.

## Revendications

1. Dispositif pour réaliser la commande impulsionnelle d'optocoupleurs pour identifier le début et la fin d'une bande magnétique, comportant
   - une source de courant servant à produire un courant traversant une diode à luminescence,
   - un photodétecteur servant à recevoir la lumière émise par la diode à luminescence,
   - un micro-ordinateur ($\mu$C) servant à évaluer le niveau de tension présent à la sortie du photodétecteur, et
   - un interrupteur (S), qui est commandé par le micro-ordinateur et est relié à la diode à luminescence et permet, uniquement à l'état passant, le passage d'un flux de courant dans la diode à luminescence, caractérisé en ce que le micro-ordinateur ($\mu$C) commande à l'état passant l'interrupteur (S) à des intervalles de temps qui dépendent de l'état d'enroulement de la bande magnétique, et évalue le niveau de tension présent sur la sortie du photodétecteur.

$I_Q$

I

FIG. 1

S

a
s    Schaltersteuerung    1
b

+U_B

D    T

Abfage    2

R

μC

FIG. 2a

τ

FIG. 2b

$t_V$

$t_A$